# DEMANDE DE BREVET EUROPEEN

(11) **EP 3 364 100 A1**
(43) Date de publication de la demande: **22.08.2018**
(21) Numéro de dépôt: 18156170.5
(22) Date de dépôt: 09.02.2018
(51) Int. Cl.: F21S 41/19, F21S 41/663, F21S 43/33, F21S 45/47, F21S 41/147, H01L 33/08, H01L 33/24, H01L 33/40, H01L 33/64, F21V 23/00, H01L 25/075, F21V 29/70, H01L 27/15

(54) **MODULE LUMINEUX À ENCOMBREMENT RÉDUIT**

(30) Priorité: 17.02.2017 FR 1751283
(71) Demandeur: Valeo Vision, 93012 Bobigny Cedex (FR)
(72) Inventeur: REISS, Benoit, 93012 Bobigny Cedex (FR)
(74) Mandataire: Valeo Vision

(57) **Abrégé**

L'invention concerne un module lumineux (2), notamment d'éclairage et/ou de signalisation, notamment pour véhicule automobile, comprenant :
une source lumineuse comprenant une pluralité d'unités électroluminescentes (8) de dimensions submillimétriques, au moins un premier ensemble (300.1) d'unités électroluminescentes (8) étant en saillie d'une première face (16) d'un premier substrat (10) ;
un premier support (14) adapté pour dissiper la chaleur du premier ensemble (300.1) d'unités électroluminescentes (8), ledit premier support (14) étant relié à une deuxième face (12) du premier substrat ;
dans lequel le premier support (14) est en outre adapté pour former une première électrode du premier ensemble (300.1) d'unités électroluminescentes (8) pour conduire un courant au premier ensemble (300.1) d'unités électroluminescentes (8).

## Description

L'invention a trait au domaine de l'éclairage et/ou de la signalisation, notamment pour véhicules automobiles.

Elle trouve notamment des applications dans les feux avant ou arrière, la carrosserie ou l'habitacle d'un véhicule automobile.

Les sources de lumière utilisées dans des modules lumineux pour l'éclairage et la signalisation dans les véhicules automobiles sont de plus en plus fréquemment constituées par des diodes électroluminescentes, notamment pour des avantages d'encombrement et d'autonomie par rapport à des sources de lumière classiques. L'utilisation de diodes électroluminescentes dans les modules d'éclairage et/ou de signalisation a permis en outre aux acteurs du marché (fabricant d'automobiles et concepteur de modules d'éclairage et/ou de signalisation) d'apporter une touche créative à la conception de ces modules, notamment par l'utilisation d'un nombre toujours plus grand de ces diodes électroluminescentes pour réaliser des effets optiques.

Il est toutefois nécessaire de dissiper la chaleur émise par les diodes électroluminescentes.

A cet effet, on connaît de l'art antérieur des diodes électroluminescentes de types SMD, pour « *Single Mounted Device* » en anglais, montées sur un substrat de type circuit imprimé ou SMI pour Substrat Métallique Isolé, lui-même monté sur un radiateur adapté pour dissiper la chaleur.

Les connexions électriques des différentes diodes électroluminescentes se font via des connecteurs ramenés sur le circuit imprimé qui comprend l'ensemble des pistes électriques.

Toutefois, l'utilisation de connecteurs et d'un circuit imprimé complet engendre un encombrement important et la dissipation thermique est limitée par la présence du circuit imprimé entre les diodes électroluminescentes et le radiateur.

De plus, une telle solution requiert de prendre en compte le circuit imprimé pour monter un réflecteur et il existe un risque de réflexion visible du circuit imprimé par le réflecteur.

Une autre solution connue consiste à coller à l'aide d'une colle thermiquement conductrice une diode électroluminescente directement sur un radiateur, le courant étant amené via deux fils soudés sur le dessus de la diode électroluminescente et reliés via un circuit imprimé. On notera qu'une telle colle est très peu conductrice électriquement voire isolante.

Une telle solution requiert toujours un circuit imprimé complexe avec de nombreuses connexions électriques et donc un encombrement important pour le module lumineux.

La présente invention vient améliorer la situation.

Un premier aspect de l'invention concerne un module lumineux, notamment d'éclairage et/ou de signalisation, notamment pour véhicule automobile, comprenant :
une source lumineuse comprenant une pluralité d'unités électroluminescentes de dimensions submillimétriques, au moins un premier ensemble d'unités électroluminescentes étant en saillie d'une première face d'un premier substrat
un premier support adapté pour dissiper la chaleur du premier ensemble d'unités électroluminescentes, le premier support étant relié à une deuxième face du premier substrat. Le premier support est en outre adapté pour former une première électrode du premier ensemble d'unités électroluminescentes pour conduire un courant au premier ensemble d'unités électroluminescentes.

L'action de «conduire un premier courant au premier ensemble d'unités électroluminescentes » couvre à la fois le fonctionnement d'une cathode et le fonctionnement d'une anode selon l'invention. Ainsi, le premier support réalise soit la fonction de cathode soit la fonction d'anode du premier ensemble d'unités électroluminescentes.

La réalisation d'une électrode sur la base de la source lumineuse est permise par l'utilisation d'une source lumineuse comprenant des unités électroluminescentes de dimensions submillimétriques, technologie aussi appelée source lumineuse monolithique. Ces unités électroluminescentes peuvent présenter une forme de bâtonnets de dimensions submillimétriques ou de plots de dimensions submillimétriques. En effet, selon une telle technologie, la cathode est directement située sur la base de la source lumineuse et donc la source lumineuse peut être connectée via son support.

L'encombrement dû au module lumineux est ainsi considérablement réduit par l'utilisation combinée du support revendiqué et d'une source lumineuse de type monolithique.

Selon un mode de réalisation de l'invention, la pluralité d'unités électroluminescentes peut comprendre en outre un deuxième ensemble d'unités électroluminescentes en saillie d'une première face d'un deuxième substrat

L'utilisation de plusieurs ensembles d'unités électroluminescentes permet la réalisation de fonctions lumineuses plus complexes.

En complément, le premier support peut en outre être relié à une deuxième face du deuxième substrat et peut en outre être adapté pour former une première électrode du deuxième ensemble d'unités électroluminescentes pour conduire le courant au deuxième ensemble d'unités électroluminescentes, et le premier substrat et le deuxième substrat peuvent en outre être reliés à des deuxièmes électrodes respectives.

Ainsi, les premier et deuxième ensembles d'unités électroluminescentes peuvent être connectés électriquement en parallèle tout en utilisant un même support, réduisant ainsi la complexité et l'encombrement du module lumineux.

En complément, les deuxièmes électrodes peuvent être reliées électriquement à un même circuit imprimé.

Une seule connexion filaire est alors nécessaire par ensemble d'unités électroluminescentes, les connexions filaires étant reliées à un même circuit imprimé, ce qui permet de réduire la complexité et l'encombrement du module lumineux.

En complément, le circuit imprimé et le premier support peuvent être reliés mécaniquement.

L'installation du module lumineux dans un véhicule automobile est ainsi facilitée.

Par exemple, le circuit imprimé peut être surmoulé sur le premier support.

En variante, le module lumineux peut comprendre en outre un deuxième support relié à une deuxième face du deuxième substrat, le deuxième support étant en outre adapté pour former une première électrode du deuxième ensemble d'unités électroluminescentes pour conduire un courant au deuxième ensemble d'unités électroluminescentes, le premier support peut en outre être relié à une deuxième électrode du deuxième ensemble d'unités électroluminescentes.

Les premier et deuxième ensembles d'unités électroluminescentes peuvent ainsi être connectés électriquement en série, ce qui réduit l'encombrement, en particulier le nombre de connexions filaires, comparativement à une connexion en parallèle.

En complément, le premier support et le deuxième support peuvent être reliés mécaniquement par une pièce de structure isolante électriquement.

L'installation du module lumineux dans un véhicule automobile est ainsi facilitée.

Par exemple, la pièce de structure peut être de type thermoplastique.

En outre, la pièce de structure comprend en outre des ajours afin de dissiper la chaleur.

La dissipation de la chaleur par le module lumineux est ainsi améliorée.

En variante, le module lumineux peut comprendre en outre un élément optique, le premier support et le deuxième support étant reliés mécaniquement par l'élément optique, l'élément optique étant apte à dévier des rayons lumineux issus du premier ensemble d'unités électroluminescentes et/ou du deuxième ensemble d'unités électroluminescentes.

L'élément optique remplit ainsi à la fois une fonction optique et mécanique ce qui réduit l'encombrement du module lumineux.

En complément, le module lumineux peut comprendre en outre un interrupteur, l'interrupteur reliant le premier support à la deuxième électrode du deuxième ensemble d'unités électroluminescentes et étant apte à sélectivement relier ou séparer électriquement le premier support et la deuxième électrode du deuxième ensemble d'unités électroluminescentes.

Un tel mode de réalisation rend possible la réalisation de fonctions lumineuses distinctes par un unique module lumineux.

En variante, le premier support peut en outre être conformé pour dévier des rayons lumineux issus du premier ensemble d'unités électroluminescentes.

Ainsi, le support remplit à la fois une fonction de support, de radiateur et une fonction optique, réduisant ainsi l'encombrement et la complexité du module lumineux.

Un deuxième aspect de l'invention concerne un dispositif lumineux pour véhicule automobile comprenant un module lumineux selon le premier aspect de l'invention. Le dispositif lumineux peut être un projecteur avant de véhicule, un feux arrière de véhicule, un élément de l'éclairage intérieur du véhicule.

Selon un mode de réalisation, le dispositif lumineux peut comprendre en outre une glace extérieure et le dispositif lumineux peut être placé à proximité de la glace extérieure.

Un troisième aspect de l'invention concerne un véhicule automobile comprenant un module lumineux selon le premier aspect de l'invention et/ou un dispositif lumineux selon le deuxième aspect de l'invention.

D'autres caractéristiques et avantages de l'invention apparaîtront à l'examen de la description détaillée ci-après, et des dessins annexés sur lesquels:
- la figure 1 illustre un module lumineux selon un mode de réalisation de l'invention;
- la figure 2 illustre une source lumineuse selon un mode de réalisation de l'invention ;
- la figure 3 illustre un module lumineux selon un mode de réalisation de l'invention ;
- la figure 4 illustre un module lumineux selon un mode de réalisation de l'invention ;
- la figure 5 illustre un module lumineux selon un mode de réalisation de l'invention ;
- la figure 6 illustre un module lumineux selon un mode de réalisation de l'invention ;
- la figure 7 illustre un module lumineux selon un mode de réalisation de l'invention.

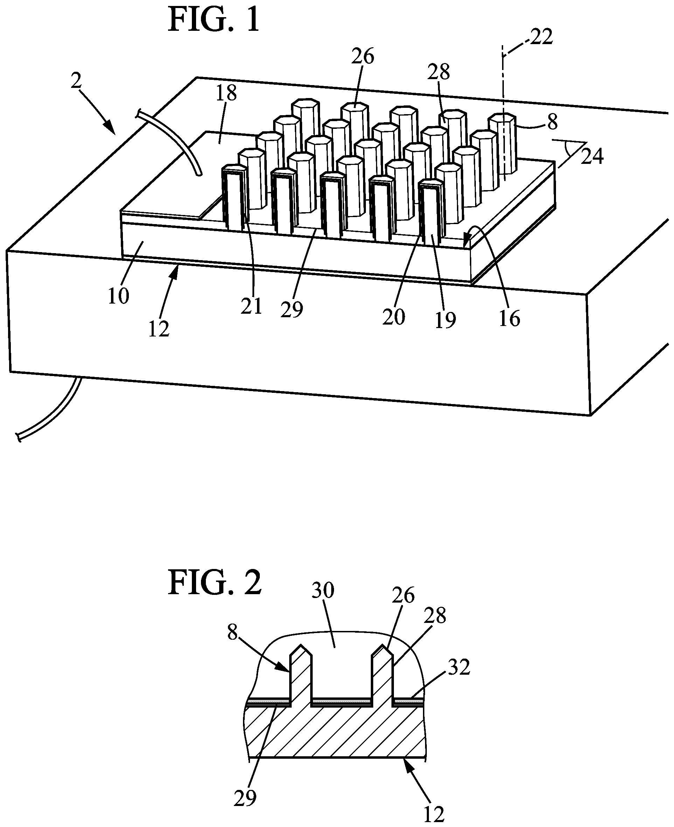

La figure 1 illustre un module lumineux 2 pour l'éclairage et/ou la signalisation, notamment pour véhicule automobile, selon un mode de réalisation de l'invention.

En référence à la figure 1, le module 2 comprend une source de lumière électroluminescente qui comprend une pluralité d'unités électroluminescentes 8 de dimensions submillimétriques, Ces unités électroluminescentes prennent la forme de bâtonnets que l'on appellera par la suite bâtonnets électroluminescents. Alternativement elles peuvent prendre la forme de plots.

Sur la figure 2, les bâtonnets électroluminescents sont groupés en un premier ensemble de bâtonnets électroluminescents. Toutefois, comme illustré dans ce qui suit, la source de lumière peut comprendre plusieurs ensembles de bâtonnets électroluminescents. On appelle « *ensemble de bâtonnets électroluminescents* » un groupe de bâtonnets électroluminescents adressable individuellement, donc indépendamment des autres groupes.

Les bâtonnets électroluminescents 8 du premier ensemble prennent naissance sur un même substrat 10. Chaque bâtonnet électroluminescent, ici formé par utilisation de nitrure de gallium GaN, s'étend perpendiculairement, ou sensiblement perpendiculairement, en saillie de substrat, ici réalisé à base de silicium, d'autres matériaux comme du carbure de silicium pouvant être utilisés pour le substrat sans sortir du contexte de l'invention. A titre d'exemple, les bâtonnets électroluminescents pourraient être réalisés à partir d'un composé à base de nitrure d'aluminium et de nitrure de gallium AlGaN, ou à partir d'un composé à base d'aluminium, d'indium et de gallium.

Sur la figure 1, le substrat 10 présente une face inférieure 12, sur laquelle est rapportée une première électrode 14, et une face supérieure 16, en saillie de laquelle s'étendent les bâtonnets électroluminescents 8 et sur laquelle est rapportée une deuxième électrode 18.

Différentes couches de matériaux sont superposées sur la face supérieure 16, notamment après la croissance des bâtonnets électroluminescents depuis le substrat ici obtenue par une approche ascendante.

De manière avantageuse, la première électrode 14 est un premier support adapté pour dissiper la chaleur du premier ensemble de bâtonnets électroluminescents.

Parmi ces différentes couches, on peut trouver au moins une couche de matériau conducteur électriquement, afin de permettre l'alimentation électrique des bâtonnets électroluminescents. Cette couche est gravée de manière à relier les bâtonnets de la source de lumière électroluminescente 3 entre eux.

Les bâtonnets électroluminescents de dimensions submillimétriques s'étirent depuis le substrat et comportent, tel que cela est visible sur la figure 1, chacun possède un noyau 19 en nitrure de gallium, autour duquel sont disposés des puits quantiques 20 formés par une superposition radiale de couches de matériaux différents, ici du nitrure de gallium et du nitrure de gallium-indium ou de nitrure d'aluminium gallium indium, et une coque 21 entourant les puits quantiques également réalisée en nitrure de gallium.

Chaque bâtonnet électroluminescent s'étend selon un axe longitudinal 22 définissant sa hauteur, la base 23 de chaque bâtonnet électroluminescent étant disposée dans un plan 24 de la face supérieure 16 du substrat 10.

Les bâtonnets électroluminescents 8 du premier ensemble présentent avantageusement la même forme. Ces bâtonnets sont chacun délimité par une face terminale 26 et par une paroi circonférentielle 28 qui s'étend le long de l'axe longitudinal. Lorsque les bâtonnets électroluminescents sont dopés et font l'objet d'une polarisation, la lumière résultante en sortie de la source de lumière électroluminescente est émise principalement à partir de la paroi circonférentielle 28, étant entendu que l'on peut prévoir que des rayons lumineux sortent également, au moins en petite quantité, à partir de la face terminale 26. Il en résulte que chaque bâtonnet agit comme une unique diode électroluminescente et que la densité des bâtonnets électroluminescents 8 améliore la luminance de la source de lumière électroluminescente.

La paroi circonférentielle 28 d'un bâtonnet électroluminescent 8, correspondant à la coquille de nitrure de gallium, est recouverte par une couche d'oxyde conducteur transparent (TCO) 29 qui forme l'anode de chaque bâtonnet complémentaire à la cathode formée par le substrat.

Cette paroi circonférentielle 28 s'étend le long de l'axe longitudinal 22 depuis le substrat 10 jusqu'à la face terminale 26, la distance de la face terminale 26 à la face supérieure 16 du substrat, depuis laquelle prennent naissance les bâtonnets électroluminescents 8, définissant la hauteur de chaque bâtonnet électroluminescent. A titre d'exemple, on peut prévoir que la hauteur d'un bâtonnet électroluminescent 8 est comprise entre 1 et 10 micromètres, tandis que l'on peut prévoir que la plus grande dimension transversale de la face terminale, perpendiculairement à l'axe longitudinal 22 du bâtonnet électroluminescent concerné, soit inférieure à 2 micromètres. On peut également prévoir de définir la surface d'un bâtonnet, dans un plan de coupe perpendiculaire à cet axe longitudinal 22, dans une plage de valeurs déterminées, et notamment entre 1,96 et 4 micromètres carré.

Ces dimensions, données à titre d'exemple non limitatif, permettent de démarquer une source de lumière comprenant des bâtonnets électroluminescents d'une source de lumière à diodes électroluminescentes planes.

On pourra également prévoir d'autres dimensionnements particuliers de la source de lumière électroluminescente selon l'invention. La densité des bâtonnets et la superficie de la surface éclairante peuvent notamment être calculées pour que la luminance obtenue par la pluralité de bâtonnets électroluminescents soit par exemple d'au moins 60 Cd/mm². On comprend que, lors de la formation des bâtonnets 8, la hauteur peut être modifiée d'un ensemble de bâtonnets électroluminescents à un autre, de manière à accroître la luminance de la source de lumière électroluminescente lorsque la hauteur est augmentée. La hauteur des bâtonnets peut également être modifiée au sein d'un même ensemble de bâtonnets électroluminescents, de sorte qu'un groupe de bâtonnets peut avoir une hauteur différente d'un autre groupe de bâtonnets d'un autre ensemble de bâtonnets électroluminescents.

La forme des bâtonnets électroluminescents 8 peut également varier d'un ensemble de bâtonnets électroluminescents à un autre, notamment sur la section des bâtonnets et sur la forme de la face terminale 26. Il a été illustré, sur la figure 1, des bâtonnets électroluminescents présentant une forme générale cylindrique, et notamment de section polygonale, ici plus particulièrement hexagonale. On comprend qu'il importe que la lumière puisse être émise à travers la paroi circonférentielle, que celle-ci présente une forme polygonale ou circulaire par exemple.

Par ailleurs, la face terminale 26 peut présenter une forme sensiblement plane et perpendiculaire à la paroi circonférentielle, de sorte qu'elle s'étend sensiblement parallèlement à la face supérieure 16 du substrat 10, tel que cela est illustré sur la figure 1, ou bien elle peut présenter une forme bombée ou en pointe en son centre, de manière à multiplier les directions d'émission de la lumière sortant de cette face terminale, tel que cela est illustré sur la figure 2.

Sur la figure 1, les bâtonnets électroluminescents 8 du premier ensemble sont agencés en matrice à deux dimensions. Cet agencement pourrait être tel que les bâtonnets électroluminescents 8 soient agencés en quinconce. L'invention couvre d'autres répartitions des bâtonnets électroluminescents, avec notamment des densités de bâtonnets qui peuvent être variables d'un ensemble de bâtonnets à un autre, et qui peuvent être variables selon différentes zones d'un même ensemble de bâtonnets.

Le premier ensemble de bâtonnets électroluminescents 8 peut comprendre en outre, tel qu'illustré sur la figure 2, une couche 30 d'un matériau polymère dans laquelle des bâtonnets électroluminescents 8 sont au moins partiellement noyés. La couche 30 peut ainsi s'étendre sur toute l'étendue du substrat ou seulement autour d'un groupe déterminé de bâtonnets électroluminescents 8. Le matériau polymère, qui peut notamment être à base de silicone, permet de protéger les bâtonnets électroluminescents 8 sans gêner la diffusion des rayons lumineux. En outre, il est possible d'intégrer dans cette couche 30 de matériau polymère des moyens de conversion de longueur d'onde, et par exemple des luminophores, aptes à absorber au moins une partie des rayons émis par l'un des bâtonnets et à convertir au moins une partie de ladite lumière d'excitation absorbée en une lumière d'émission ayant une longueur d'onde différente de celle de la lumière d'excitation.

La source de lumière peut comporter en outre un revêtement 32 de matériau réfléchissant la lumière qui est disposé entre les bâtonnets électroluminescents 8 pour dévier les rayons, initialement orientés vers le substrat, vers la face terminale 26 des bâtonnets électroluminescents 8. En d'autres termes, la face supérieure 16 du substrat 10 peut comporter un moyen réfléchissant qui renvoie les rayons lumineux, initialement orientés vers la face supérieure 16, vers la face de sortie de la source de lumière. On récupère ainsi des rayons qui autrement seraient perdus. Ce revêtement 32 est disposé entre les bâtonnets électroluminescents 8 sur la couche d'oxyde conducteur transparent 29.

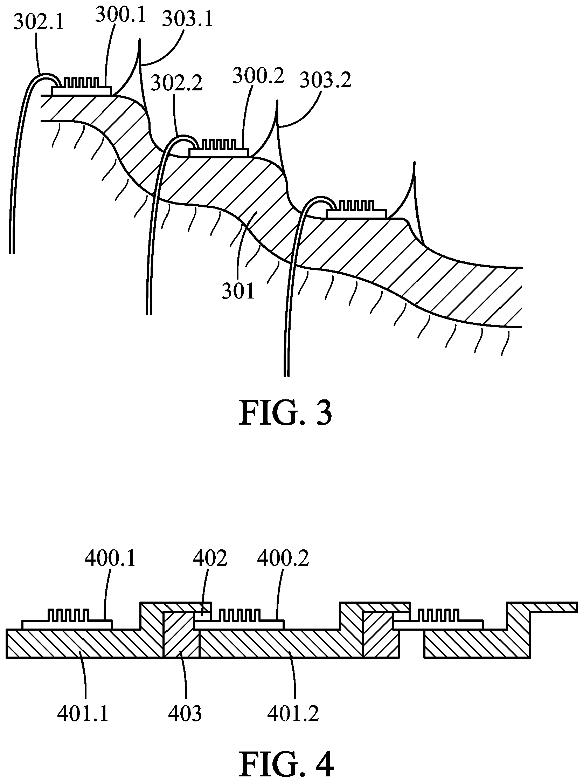

La figure 3 illustre un module lumineux selon un mode de réalisation de l'invention.

Selon ce mode de réalisation, la source lumineuse comprend plusieurs ensembles de bâtonnets électroluminescents, notamment un premier ensemble de bâtonnets électroluminescents 300.1 et un deuxième ensemble de bâtonnets électroluminescents 300.2.

Un premier support 301 est adapté pour dissiper la chaleur du premier ensemble de bâtonnets électroluminescents 300.1, le premier support étant relié à une deuxième face du premier substrat, telle que la face inférieure 12 illustrée sur la figure 1. En outre, le premier support 301 est adapté pour former une première électrode du premier ensemble de bâtonnets électroluminescents 301 pour conduire un courant au premier ensemble de bâtonnets électroluminescents

Le premier support 301 correspond ainsi à la première électrode 14 illustrée en référence à la figure 1.

Selon le mode de réalisation de la figure 3, le premier support 301 est en outre adapté pour former une première électrode du deuxième ensemble de bâtonnets électroluminescents 300.2 pour conduire un courant au deuxième ensemble de bâtonnets électroluminescents 300.2.

Le premier support 301 forme ainsi une cathode commune à plusieurs ensembles de bâtonnets électroluminescents de la source lumineuse. En outre, le premier support 301 permet de dissiper la chaleur des ensembles de bâtonnets électroluminescents sans augmenter l'encombrement du module lumineux.

Le module lumineux peut en outre comprendre des deuxièmes électrodes 302.1 et 302.2 respectivement reliés à un premier substrat du premier ensemble de bâtonnets électroluminescents 300.1 et à un deuxième substrat du deuxième ensemble de bâtonnets électroluminescents 300.2.

Les deuxièmes électrodes 302.1 et 302.2 peuvent ensuite être reliées électriquement à un même circuit imprimé, non représenté sur la figure 3. Le circuit imprimé et le premier support 301 peuvent être reliés mécaniquement. Par exemple, le circuit imprimé peut être surmoulé sur le premier support 301, ou le circuit imprimé et le premier support 301 peuvent être surmoulés sur un autre support commun.

Le mode de réalisation de la figure 3 permet ainsi d'alimenter les ensembles de bâtonnets électroluminescents 300.1 et 300.2 en parallèle, avec un encombrement moindre comparativement aux solutions de l'art antérieur.

De manière complémentaire, le module d'émission lumineuselumineux peut comprendre au moins un premier élément optique 303.1. L'élément optique 303.1 est apte à dévier des rayons lumineux issus du premier ensemble 300.1 de bâtonnets électroluminescents et ou du deuxième ensemble 300.2 de bâtonnets électroluminescents. Le premier élément optique 303.1 peut être relié mécaniquement au premier support 301, ce qui permet d'améliorer la précision associée à la fonction de l'élément optique 302.1. Par exemple, le premier élément optique 303.1 peut être monté de manière simple sur le premier support 301, tel que par tout méthode classique de fixation par crimpage, clipsage, vissage, soudure laser ou autre.

En variante, le premier élément optique 303.1 est indissociable du premier support 301. Il peut notamment être venu de matière avec le support 301. Par exemple, le premier support 301 peut être conformé pour dévier des rayons lumineux issus du premier ensemble 301.1 de bâtonnets électroluminescents et/ou du deuxième ensemble 301.2 de bâtonnets électroluminescents.

Un deuxième élément optique 303.2 est représenté sur la figure 3.

Aucune restriction n'est attachée aux éléments optiques 303.1 et 303.2 qui peuvent être des éléments optiques simples ou à plusieurs cavités, des réflecteurs, des lentilles ou autres.

La figure 4 illustre un module lumineux selon un mode de réalisation de l'invention.

Comparativement au mode de réalisation de la figure 3, la figure 4 propose de connecter des ensembles de bâtonnets électroluminescents en série.

Comme sur la figure 3, le module lumineux représenté sur la figure 4 comprend plusieurs ensembles de bâtonnets électroluminescents, dont un premier ensemble 400.1 de bâtonnets électroluminescents et un deuxième ensemble 400.2 de bâtonnets électroluminescents.

Un premier support 401.1 est adapté pour dissiper la chaleur du premier ensemble de bâtonnets électroluminescents, le premier support étant relié à une deuxième face d'un premier substrat du premier ensemble 400.1 de bâtonnets électroluminescents, telle que la face inférieure 12 représentée sur la figure 1.

Le premier support 401.1 est en outre adapté pour former une première électrode du premier ensemble 400.1 de bâtonnets électroluminescents pour conduire un courant au premier ensemble 400.1 de bâtonnets électroluminescents.

De manière similaire au premier support 401.1, un deuxième support 401.2 est dédié au deuxième ensemble 400.2 de bâtonnets électroluminescents.

Une pièce de structure 403 peut relier mécaniquement le premier support 401.1 et le deuxième support 401.2. La pièce de structure 403 est isolante électriquement, et peut être en complément isolante thermiquement. La pièce de structure 403 peut être en un matériau thermoplastique et peut comprendre des ajours afin de dissiper la chaleur.

Comme illustré sur la figure 4, chaque support relie l'anode d'un ensemble de bâtonnets électroluminescents à la cathode de l'ensemble de bâtonnets électroluminescents qui lui est consécutif. A cet effet, un élément de connexion 402 peut servir de jonction électrique entre le premier support 401.1 et l'anode du deuxième ensemble 400.2 de bâtonnets électroluminescents.

Un tel montage permet d'éviter l'utilisation de toute connexion électrique filaire, réduisant ainsi l'encombrement du module lumineux.

Comme pour le mode de réalisation de la figure 3, le module lumineux de la figure 4 peut intégrer des éléments optiques, non représentés sur la figure 4.

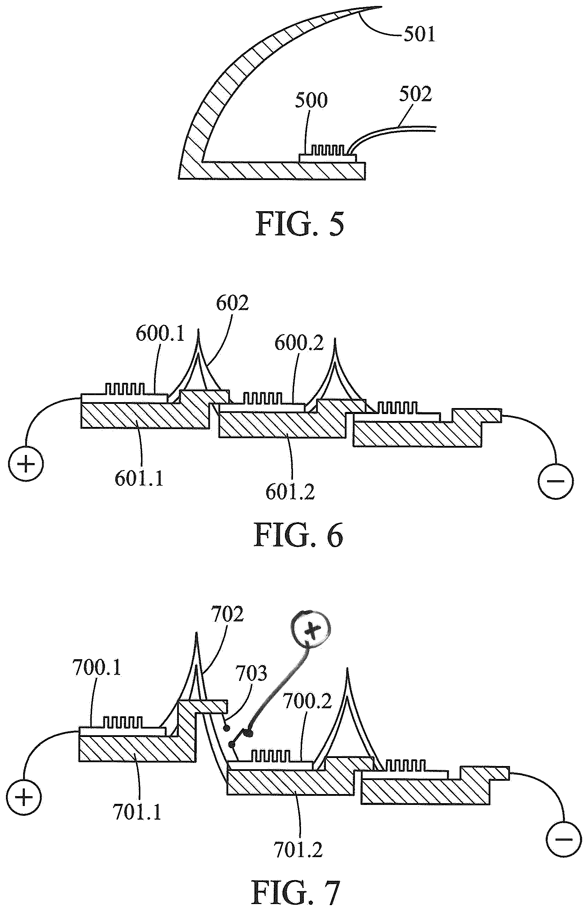

La figure 5 présente un module lumineux selon un mode de réalisation de l'invention.

Le module lumineux comprend un premier ensemble de bâtonnets électroluminescents 500 ainsi qu'un premier support 501 adapté pour dissiper la chaleur du premier ensemble de bâtonnets électroluminescents, le premier support étant relié à une deuxième face d'un substrat du premier ensemble de bâtonnets électroluminescents. Le premier support 501 est en outre adapté pour former une première électrode du premier ensemble 500 de bâtonnets électroluminescents pour conduire un courant au premier ensemble de bâtonnets électroluminescents. Une deuxième électrode est reliée à une connexion filaire 502.

En outre, le premier support 501 est conformé pour dévier des rayons lumineux issus du premier ensemble de bâtonnets électroluminescents. Le premier support 501 a ainsi un rôle de réflecteur en plus de son rôle d'électrode ou de radiateur, ce qui permet de réduire considérablement l'encombrement et la complexité du module lumineux.

Le mode de réalisation de la figure 5 peut être combiné avec le mode de réalisation de la figure 3 ou de la figure 4 afin d'intégrer plusieurs ensembles de bâtonnets électroluminescents dans la source lumineuse du module lumineux.

La figure 6 présente un module lumineux selon un mode de réalisation de l'invention.

Le module lumineux comprend au moins un premier ensemble 600.1 de bâtonnets électroluminescents et un deuxième ensemble 600.2 de bâtonnets électroluminescents.

Comme pour le mode de réalisation illustré sur la figure 4, un premier support 601.1 est adapté pour dissiper la chaleur du premier ensemble 600.1 de bâtonnets électroluminescents, le premier support 601.1 étant relié à une deuxième face d'un substrat du premier ensemble 600.1 de bâtonnets électroluminescents et un deuxième support 601.2 est adapté pour dissiper la chaleur du deuxième ensemble 600.2 de bâtonnets électroluminescents, le deuxième support 601.2 étant relié à une deuxième face d'un substrat du deuxième ensemble 600.2 de bâtonnets électroluminescents. Le premier support 601.1 est en outre adapté pour former une première électrode du premier ensemble 600.1 de bâtonnets électroluminescents pour conduire un courant au premier ensemble 600.1 de bâtonnets électroluminescents et le deuxième support 601.2 est en outre adapté pour former une première électrode du deuxième ensemble 600.2 de bâtonnets électroluminescents pour conduire un courant au deuxième ensemble 600.1 de bâtonnets électroluminescents. En outre, les ensembles de bâtonnets électroluminescents étant reliés en série, le premier support 601.1 est relié à l'anode du deuxième ensemble 601.2 de bâtonnets électroluminescents.

En outre, le module lumineux comprend un élément optique 602. Selon le mode de réalisation de la figure 5, l'élément optique 602 relie mécaniquement le premier support 601.1 au deuxième support 601.2, ce qui permet d'éviter d'ajouter la pièce de structure 403 illustrée sur la figure 4. Par exemple, l'élément optique 602 peut être monté de manière simple sur le premier support 601.1 et sur le deuxième support 601.2, tel que par tout méthode classique de fixation par crimpage, clipsage, vissage, soudure laser ou autre.

La figure 7 présente un module lumineux selon un mode de réalisation de l'invention.

Le module lumineux comprend un premier ensemble 700.1 et un deuxième ensemble 700.2 de bâtonnets électroluminescents, un premier support 701.1, un deuxième support 701.2 et un élément optique 702, reliés de la même manière que celle présentée en référence à la figure 6. Toutefois, à la différence du mode de réalisation présenté en référence à la figure 6, un interrupteur 703 reliant le premier support 701.1 à la deuxième électrode du deuxième ensemble 700.2 de bâtonnets électroluminescents et étant apte à sélectivement relier ou séparer électriquement le premier support 701.1 et la deuxième électrode du deuxième ensemble 700.2 de bâtonnets électroluminescents.

L'interrupteur 703 peut être réalisé par un montage à base de transistors par exemple. L'utilisation d'un interrupteur est particulièrement avantageuse lorsque plusieurs fonctions d'éclairage sont réalisées par le module lumineux, ou afin de commander indépendamment des ensembles de bâtonnets électroluminescents malgré leur montage en série. L'interrupteur 703 permet ainsi de séparer les différentes fonctions réalisées par le module lumineux. De manière alternative à l'utilisation d'un interrupteur, l'invention peut prévoir une isolation électrique entre des ensembles de bâtonnets électroluminescents réalisant des fonctions distinctes. Les circuits électriques à réaliser pour sélectionner une fonction d'éclairage sont bien connus de la personne du métier et ne sont pas décrits davantage.

De manière avantageuse, les supports des modules lumineux présentés précédemment, peuvent être placés à proximité d'une glace extérieure du phare ou projecteur afin de créer une zone plus chaude et donc réduire les effets de la condensation sur ce phare.

De plus, l'utilisation d'un support tel que décrit en référence aux figures permet d'utiliser de tels supports en tant que mise à la masse électromagnétique, en particulier dans le cadre de l'utilisation de LED pulsées. Les supports peuvent ainsi remplir une fonction de blindage pour protéger les véhicules des émissions des sources qui y sont fixées et qui risquent d'être perturbantes, notamment dans le cas où les sources sont alimentées par des courants impulsionnels.

Bien entendu, l'invention n'est pas limitée aux modes de réalisation décrits précédemment et fournis uniquement à titre d'exemple. Elle englobe diverses modifications, formes alternatives et autres variantes que pourra envisager l'homme du métier dans le cadre de la présente invention et notamment toutes combinaisons des différents modes de réalisation décrits précédemment.

## Revendications

1. Module lumineux (2), notamment d'éclairage et/ou de signalisation, notamment pour véhicule automobile, comprenant :
une source lumineuse comprenant une pluralité d'unités électroluminescentes (8) de dimensions submillimétriques, au moins un premier ensemble d'unités électroluminescentes étant en saillie d'une première face (12) d'un premier substrat (10) ;
un premier support (14) adapté pour dissiper la chaleur du premier ensemble d'unités électroluminescentes, ledit premier support étant relié à une deuxième face du premier substrat ;
dans lequel le premier support est en outre adapté pour former une première électrode du premier ensemble d'unités électroluminescentes pour conduire un courant au premier ensemble d'unités électroluminescentes.

2. Module lumineux selon la revendication 1, dans lequel la pluralité d'unités électroluminescentes (8) comprend en outre un deuxième ensemble d'unités électroluminescentes en saillie d'une première face d'un deuxième substrat.

3. Module lumineux selon la revendication 2, dans lequel le premier support est en outre relié à une deuxième face (16) du deuxième substrat et est en outre adapté pour former une première électrode du deuxième ensemble d'unités électroluminescentes pour conduire le courant au deuxième ensemble d'unités électroluminescentes,
dans lequel le premier substrat et le deuxième substrat sont en outre reliés à des deuxièmes électrodes respectives.

4. Module lumineux selon la revendication 3, dans lequel les deuxièmes électrodes sont reliées électriquement à un même circuit imprimé.

5. Module lumineux selon la revendication 4, dans lequel le circuit imprimé et le premier support sont reliés mécaniquement.

6. Module lumineux selon la revendication 5, dans lequel le circuit imprimé est surmoulé sur le premier support.

7. Module lumineux selon la revendication 2, comprenant en outre un deuxième support relié à une deuxième face (16) du deuxième substrat (10), ledit deuxième support étant en outre adapté pour former une première électrode du deuxième ensemble d'unités électroluminescentes pour conduire un courant au deuxième ensemble d'unités électroluminescentes,
dans lequel le premier support est en outre relié à une deuxième électrode du deuxième ensemble d'unités électroluminescentes.

8. Module lumineux selon la revendication 7, dans lequel le premier support et le deuxième support sont reliés mécaniquement par une pièce de structure (403) isolante électriquement.

9. Module lumineux selon la revendication 8, dans lequel la pièce de structure (403) est de type thermoplastique.

10. Module lumineux selon la revendication 8 ou 9, dans lequel la pièce de structure (403) comprend en outre des ajoures afin de dissiper la chaleur.

11. Module lumineux selon la revendication 7, comprenant en outre au moins un élément optique (602 ; 702), dans lequel le premier support et le deuxième support sont reliés mécaniquement par ledit élément optique, ledit élément optique étant apte à conduire des rayons lumineux issus du premier ensemble d'unités électroluminescentes et/ou du deuxième ensemble d'unités électroluminescentes.

12. Module lumineux selon la revendication 11, comprenant en outre un interrupteur (703), ledit interrupteur reliant le premier support à la deuxième électrode du deuxième ensemble d'unités électroluminescentes et étant apte à sélectivement relier ou séparer électriquement le premier support et la deuxième électrode du deuxième ensemble d'unités électroluminescentes.

13. Module lumineux selon la revendication 1, dans lequel le premier support est en outre conformé pour conduire des rayons lumineux issus du premier ensemble d'unités électroluminescentes.

14. Module lumineux selon l'une quelconque des revendications précédentes, dans lequel les unités électroluminescentes présentent une forme de bâtonnets.

15. Dispositif lumineux pour véhicule automobile comprenant un module lumineux selon l'une des revendications 1 à 14.
